Europäisches Patentamt

European Patent Office

Office européen des brevets

(19)

(11) Veröffentlichungsnummer: **0 498 952 A1**

(12) **EUROPÄISCHE PATENTANMELDUNG**

(21) Anmeldenummer: **91120942.7**

(22) Anmeldetag: **06.12.91**

(51) Int. Cl.5: **H01R 4/48**, H05K 7/02

(30) Priorität: **15.02.91 DE 4104653**

(43) Veröffentlichungstag der Anmeldung:
**19.08.92 Patentblatt 92/34**

(84) Benannte Vertragsstaaten:
**AT BE CH DE DK ES FR GB GR IT LI LU NL SE**

(71) Anmelder: **Melitta Haushaltsprodukte GmbH &
Co. Kommanditgesellschaft
Ringstrasse 99
W-4950 Minden 1(DE)**

(72) Erfinder: **Salomon, Thomas, Dipl.-Ing.
An der Brücke 19
W-4800 Bielefeld 14(DE)**

(74) Vertreter: **Loesenbeck, Karl-Otto, Dipl.-Ing. et
al
Jöllenbecker Strasse 164
W-4800 Bielefeld 1(DE)**

(54) **Elektrische Flachsteckverbindung.**

(57) Bei dieser elektrischen Steckverbindung ist zur Aufnahme der üblichen Steckfahnen der Steckerteile in einem ebenen Aufnahmeteilabschnitt (1) aus elektrisch leitendem Material eine Steckfahnenaufnahme durch einen Steckschlitz (2) gebildet, in dessen Kontur eine durch Freischneidung gebildete Kontaktzunge (3) vorsteht. Die gesamte Steckfahnenaufnahme kann in einfacher Weise durch einen Stanzvorgang gebildet werden.

Fig. 1

Die vorliegende Erfindung betrifft eine elektrische Flachsteckverbindung mit einem mindestens eine Steckfahne aufweisenden Steckerteil und einem Aufnahmeteil mit mindestens einer elektrisch leitenden Steckfahnenaufnahme.

Bei den üblichen Flachsteckverbindungen dieser Art ist die elektrisch leitende Steckfahnenaufnahme des Aufnahmeteiles ein Formkörper, der buchsenförmig, käfigförmig oder schuhförmig ausgebildet ist. Selbst bei Steckverbindungsausgestaltungen, bei denen das Aufnahmeteil ebene Abschnitte aufweist, wie es beispielsweise bei Leiterplattenanschlüssen oder Stanzgitteranschlüssen der Fall ist, sind die Aufnahmeteile dann aus der Ebene hochgebogene Formkörper. Beispielsweise die Stanzgitterherstellung wird dadurch beträchtlich verkompliziert, da neben dem Stanzen ein Hochbiegen und ein weiterer Formgebungsvorgang erforderlich sind.

Der vorliegenden Erfindung liegt von daher die Aufgabe zugrunde, eine elektrische Flachsteckverbindung zu schaffen, die bei Gewährleistung einer guten elektrischen Kontaktierung besonders einfach herzustellen ist.

Die erfindungsgemäße Lösung ergibt sich aus dem kennzeichnenden Teil des Patentanspruches 1. Danach ist die Steckfahnenaufnahme nunmehr ein einfach in dem ebenen Aufnahmeteilabschnitt herzustellender Steckschlitz, in den eine in dem ebenen Aufnahmeteilabschnitt freigeschnittene Kontaktzunge vorsteht. Als Herstellungsvorgang ist nur noch das Stanzen erforderlich, da die Bildung des Steckschlitzes und die Freischneidung der Kontaktzunge eben bei diesem Stanzvorgang vollzogen werden können. Dadurch, daß die freigeschnittene Kontaktzunge ein wenig in den Steckschlitz für die Steckfahne des Steckerteiles vorsteht, kommt es beim Einstecken der Steckfahne in den Steckschlitz zu einem leichten Herausbiegen der Kontaktzunge aus der Ebene in Verbindung mit einer sehr guten Kontaktierung zwischen der dann unter leichter Biegespannung stehenden Kontaktzunge und der Steckfahne des Steckerteiles.

Weitere bevorzugte Ausgestaltungen sind in den Unteransprüchen gekennzeichnet. So kann die Kontaktierung noch verbessert werden, wenn man der Kontaktzunge beim Freischneiden einen leicht verbreiterten Kontaktbereich an ihrem freien Ende gibt.

Eine besonders gute Kontaktierung, gleichzeitig unter Erzeugung einer auch mechanisch beträchtlichen Rückhaltekraft läßt sich dadurch erzeugen, daß man in den Steckschlitz von beiden Seiten her zwei einander gegenüberliegende Kontaktzungen vorstehen läßt.

Sind in einem Anwendungsfall gleichzeitig zahlreiche Steckverbindungen unter Kontaktgabe zu stecken, kann es zweckmäßig sein, die Kontaktzungen beim Stanzvorgang schon gleich ein wenig aus ihrer Ebene im Sinne einer Vorbiegung herauszudrücken, um die Gesamtsteckkraft eines solchen Montagevorganges dann nicht zu groß werden zu lassen.

Eine besonders zweckmäßige Anwendungsform einer derartigen elektrischen Steckverbindung ist die Ausbildung eines Stanzgitters mit derartigen Steckschlitzen und Kontaktzungen. Wird ein derartiges Stanzgitter auf einem elektrisch nicht leitenden Träger einer das Stanzgitter aufnehmenden Schaltplatine angeordnet, werden in dem Träger im Bereich der Steckfahnenaufnahmen Aussparungen vorgesehen, um die erforderlichen Frei- und Eintrittsräume für die Steckfahnen zu haben. Ausführungsbeispiele einer elektrischen Steckverbindung gemäß der Erfindung werden nachstehend unter Bezugnahme auf die Zeichnung näher beschrieben.

Es zeigen

Figuren 1 - 3    verschiedene Steckfahnenaufnahmen einer elektrischen Flachsteckverbindung gemäß der Erfndung,

Figur 4    eine Teildraufsicht auf eine elektrische Schaltplatine mit einem Stanzgitter, an dem derartige Steckfahnenaufnahmen verwirklicht sind,

Figur 5    eine vereinfachte Teilschnittdarstellung durch eine elektrische Flachsteckverbindung gemäß der Erfindung.

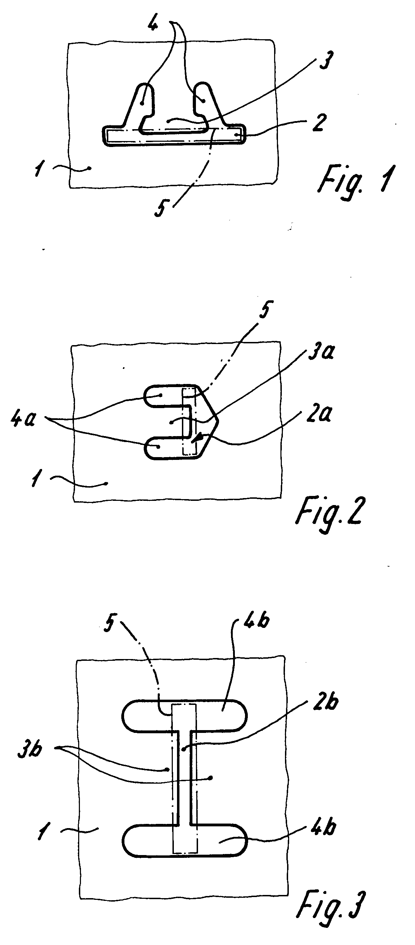

Die elektrische Flachsteckverbindung besitzt ein Aufnahmeteil 1 mit einer elektrisch leitenden Steckfahnenaufnahme, wobei in den Figuren 1 bis 3 Teilbereiche eines ebenen Abschnittes eines derartigen Aufnahmeteiles 1 dargestellt sind, in denen, jeweils in unterschiedlicher Konfiguration, verschiedene Kontaktzungen durch Freischneidung gebildet sind. Im Ausführungsbeispiel nach Figur 1 ist in dem ebenen Abschnitt des Aufnahmeteiles 1 ein Steckschlitz 2 ausgestanzt, in dessen Kontur an einer Seite eine Kontaktzunge 3 vorspringt, die durch Freischneidungen 4 in dem Aufnahmeteilabschnitt 1 gebildet ist. Die Kontur einer Steckfahne 5 eines Steckerteiles 6 der elektrischen Flachsteckverbindung ist zur Illustration strichpunktiert angedeutet. Bei der Ausführungsform nach Figur 1 hat zur Verbesserung der Kontaktierung die Kontaktzunge 3 an ihrem vorstehenden Ende eine verbreiterte Kontaktzone.

Bei der Ausführungsform nach Figur 2 ist in dem Aufnahmeteilabschntt 1 ein Steckschlitz 2a ausgebildet, während durch Freischneidungen 4a eine relativ schmale lange und damit relativ leicht verformbare Kontaktzunge 3a gebildet ist. Auch hier ist die Steckfahnenkontur strichpunktiert angedeutet.

Bei der Ausführungsform nach Figur 3 ist wiederum ein Steckschlitz 2b durch Ausstanzung gebildet, in dessen Kontur von beiden Seiten her einander gegenüberliegende relativ breite Kontaktzungen 3b vorspringen, die beide durch entsprechende Freischneidungen 4b im Material ausgebildet sind.

Die Figur 5 illustriert im Schnitt ein Steckerteil 6 mit zwei Steckfahnen 5, eingesteckt in zwei entsprechend beabstandete Steckfahnenaufnahmen beispielsweise der Konfiguration nach Figur 1, also jeweils mit dem Steckschlitz 2 und der Kontaktzunge 3.

Dadurch, daß die Kontaktzungen 3, 3a, 3b in die Kontur des Steckschlitzes 2, 2a, 2b vorstehen, liegt unter guter Kontaktgabe nach dem Einbringen der Steckfahnen 5 in die Steckschlitze die Kontaktzunge 3, 3a, 3b leicht unter Spannung aus der Ebene des ebenen Aufnahmeteilabschnittes 1 herausgebogen, wie in Figur 5 illustriert.

Sind in einem Anwendungsfall bei der Tätigung der elektrischen Flachsteckverbindung zahlreiche Steckfahnen gleichzeitig einzustecken, kann es im Hinblick auf die aufzubringende Steckkraft zweckmäßig sein, die Kontaktzungen 3, 3a, 3b bei der Freistanzung leicht ein wenig vorzubiegen, d. h. aus der Ebene des ebenen Aufnahmeteilabschnittes 1 herauszudrücken, was durch entsprechende Ausgestaltung des Stanzwerkzeuges geschehen kann.

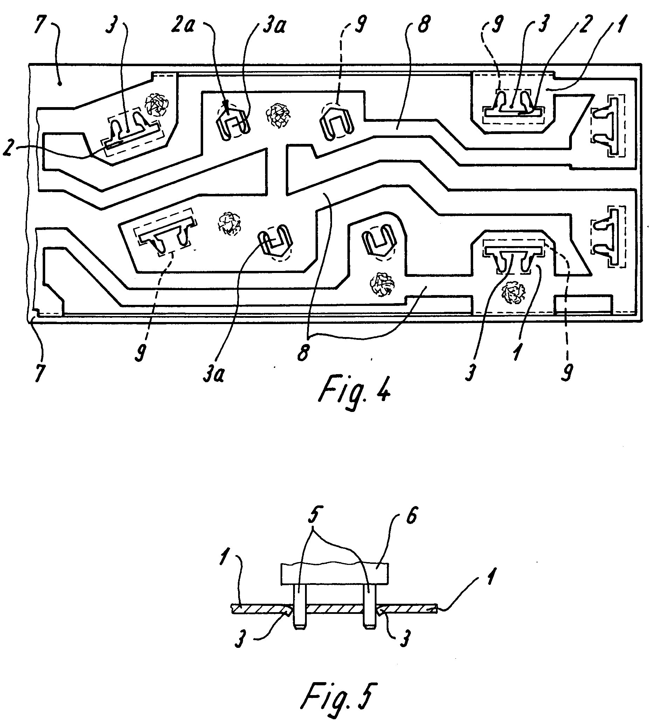

In Figur 4 ist in Draufsicht eine elektrische Schaltplatine gezeigt, bei der auf einem Trägerkörper 7 ein Stanzgitter 8 angeordnet ist, wobei das elektrische Stanzgitter 8 ein bevorzugtes Anwendungsgebiet dieser Flachsteckverbindung darstellt. Es besitzt weitestgehend ebene Gitterverläufe und bietet von daher zahlreiche ebene Abschnitte, in deren Bereichen als Aufnahmeteile 1 die in Frage stehenden Steckfahnenaufnahmen in Form der Steckschlitze 2, 2a, 2b mit den Kontaktzungen 3, 3a, 3b verwirklicht werden können. Im Ausführungsbeispiel nach Figur 4 sind verschiedene Steckschlitze 2, 2a mit Kontaktzungen 3, 3a verwirklicht. Selbstverständlich könnten in dem Stanzgitter auch Steckschlitze 2b mit jeweils zwei Kontaktzungen 3b verwirklicht werden. In dem Trägerkörper 7 sind unterhalb der Steckfahnenaufnahmen 2, 3 bzw. 2a, 3a jeweils Aussparungen 9 gebildet, damit die Steckfahnen 5 der Steckerteile 6 kollisionsfrei durch die Steckschlitze 2, 2a gesteckt werden können.

**Patentansprüche**

1. Elektrische Flachsteckverbindung, mit einem mindestens eine Steckfahne (5) aufweisenden Steckerteil (6) und einem Aufnahmeteil (1) mit mindestens einer elektrisch leitenden Steckfahnenaufnahme, **dadurch gekennzeichnet,** daß die Steckfahnenaufnahme ein in einem ebenen Aufnahmeteilabschnitt (1) gebildeter Steckschlitz (2, 2a, 2b) ist, in dessen Kontur in dem ebenen Aufnahmeteilabschnitt (1) eine freigeschnittene Kontaktzunge (3, 3a, 3b) vorsteht.

2. Elektrische Flachsteckverbindung nach Anspruch 1, dadurch gekennzeichnet, daß die Kontaktzunge (2) an ihrem freien Ende einen verbreiterten Kontaktbereich hat.

3. Elektrische Flachsteckverbindung nach Anspruch 1, dadurch gekennzeichnet, daß in die Kontur des Steckschlitzes (2b) von beiden Seiten her zwei einander gegenüberliegende Kontaktzungen (3b) vorstehen.

4. Elektrische Flachesteckverbindung nach einem der vorhergehenden Ansprüche, dadurch gekennzeichnet, daß die Kontaktzunge (3, 3a, 3b) in Einsteckrichtung der Steckfahne (5) vorgebogen ist.

5. Elektrische Flachsteckverbindung nach einem der vorhergehenden Ansprüche, dadurch gekennzeichnet, daß der ebene Aufnahmeteilabschnitt (1) Teil eines elektrischen Stanzgitters (8) ist.

6. Elektrische Flachsteckverbindung nach Anspruch 5, dadurch gekennzeichnet, daß das elektrische Stanzgitter (8) auf einem Träger (7) aus elektrisch nicht leitendem Material angeordnet ist und in diesem im Bereich der durch die Steckschlitze (2, 2a, 2b) und die Kontaktzungen (3, 3a, 3b) gebildeten Steckfahnenaufnahmen Aussparungen (9) für die Steckfahnen (5) der Steckerteile (6) vorgesehen sind.

4 3

2

1 5

*Fig. 1*

5

3a

4a

2a

1

*Fig.2*

5 4b

3b 2b

1 4b

*Fig.3*

Fig. 4

Fig. 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | US-A-4 303 297 (SMART ET AL.)  <br> * Spalte 3, Zeile 12 - Zeile 23; Abbildungen 1,2 * | 1-3 | H01R4/48 <br> H05K7/02 |
| A | | 4-6 | |
| | --- | | |
| Y | US-A-4 056 299 (PAIGE) <br> * Spalte 3, Zeile 53 - Zeile 60; Abbildungen 4-6 * | 1-3 | |
| | --- | | |
| A | US-A-4 959 018 (YAMAMOTO ET AL.) <br> * Zusammenfassung; Abbildung 1 * | 1,5,6 | |
| | ----- | | |

RECHERCHIERTE SACHGEBIETE (Int. Cl.5 )

H01R
H05K

Der vorliegende Recherchenbericht wurde für alle Patentansprüche erstellt

| Recherchenort | Abschlußdatum der Recherche | Prüfer |
|---|---|---|
| DEN HAAG | 26 MAI 1992 | HORAK A. L. |

EPO FORM 1503 03.82 (P0403)

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes
    Dokument